# EUROPEAN PATENT APPLICATION

(11) **EP 1 403 713 A1**
(43) Date of publication of application: **31.03.2004**
(21) Application number: 03256067.4
(22) Date of filing: 26.09.2003
(51) Int. Cl.: G03F 7/20

(54) **Lithographic apparatus and device manufacturing method**

(30) Priority: 30.09.2002 EP 02256793
(71) Applicant: ASML Netherlands B.V., 5503 LA Veldhoven (NL)
(72) Inventor: Jacobs, Hernes, 5627 CJ Eindhoven (NL); Cox, Henrikus Herman Marie, 5645 JH Eindhoven (NL); Vosters, Petrus Matthijs Henricus, 5531 EH Bladel (NL)
(74) Representative: Leeming, John Gerard

(57) **Abstract**

A lithographic projection apparatus in which a balance mass is supported by a base frame using a plurality of flexible supporting elements which are mechanically attached to both the base frame and balance mass. Free horizontal movement is provided by providing the supporting elements with at least two pivot points.

## Description

The present invention relates to a lithographic projection apparatus comprising:
- a radiation system for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate;
- a base frame; and
- a balance mass supported on said base frame and moveable relative to said base frame.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

In a lithographic projection apparatus, if a substrate table is moved by an actuator attached to a base frame, a reaction force is transferred to the base frame. This reaction force can be high because the acceleration of the substrate table can be of the order of 5 to 60 m/s² and a substrate table might weigh about 40 or 70 kg. This reaction force can cause deleterious vibrations or movement of the base frame.

The effect of such a reaction force can be reduced by the use of a freely mounted balance mass. This is done by putting a reaction force from a positioning actuator between the substrate table and the balance mass such that the substrate table is moved in one direction whilst the balance mass is moved by the reaction force in the opposite direction by an amount equal to the distance moved by the substrate table times the mass ratio of the substrate table to the balance mass. In this way, no substantial reaction forces are transmitted to the base frame and the centre of gravity of the balance mass and the substrate table relative to the base frame stays relatively constant.

The balance mass and substrate table are mounted, as near as possible, in a frictionless manner, e.g. using air bearings, such that no further parasitic forces are transmitted to the base frame or other parts of the lithographic projection apparatus as a result of movement of the substrate table.

To meet the ever-present demand for imaging features of reduced size, it is necessary to reduce the wavelength of radiation used for the projection beam. Thus, improved resolution requires the development of lithographic projection apparatus making use of extreme ultraviolet radiation (EUV) (e.g. with a wavelength in the range of 5-20 nm). An EUV lithographic projection apparatus must use mirrors in the projection system because no material suitable for forming refractive optical elements for EUV is known and the beam must be kept in vacuum to avoid contamination and attenuation of the beam.

Unfortunately, the requirement for the projection beam to be kept in a vacuum means that the use of air bearings for the balance mass is no longer practical. Although a design has been proposed in which the air bearings are covered by a metal bellows, this design is complicated and heavy.

It is an object of the present invention to provide a means for supporting a balance mass which is vacuum compatible. It is a further object of the present invention to provide a support which allows free movement of the balance mass without any significant parasitic stiffness in the horizontal direction.

This and other objects are achieved according to the invention in a lithographic apparatus as specified in the opening paragraph, characterized in that said balance mass is supported by at least one flexible supporting element mechanically attached to said balance mass and to said base frame and having at least two pivot points.

Thus the means for supporting the balance mass can easily be made in a vacuum compliant way and the need for complicated and expensive shielding of air bearings is avoided. The supporting element may also guide the balance mass. The element may be flexible either by way of being hinged or by being made of a material which flexes under the operational loads.

By virtue of the supporting element having at least two pivot points the supporting means presents little resistance to horizontal movement of the balance mass (preferably with zero or near-zero horizontal stiffness). Thus the balance mass moves in a similar way as when on air bearings i.e. it can move in the horizontal (or whichever) plane substantially without tilting or deviating into another plane as is the case if the balance mass is supported on springs. It should be noted that in some embodiments there is some movement of the balance mass outside of the desired plane (x, y and R_{z}). Such movements outside the desired plane can be minimized by providing sufficient vertical stiffness to the balance mass.

Preferably each supporting element is positioned, in use, below the balance mass such that, on displacement of said balance mass from an equilibrium position in which said pivot points align vertically, a horizontal force in the direction of movement of the balance mass is generated by the action of gravity on said balance mass. This allows, in combination with an elastic means to provide a compensating force on said balance mass opposite in direction to said horizontal force generated by gravity, the horizontal stiffness of the balance mass to be made close to zero by arranging for the compensating force to be equal in magnitude to the horizontal force such that the balance mass can be operated in a near perfect way. In some applications (for example see EP 02253970.4 herein incorporated in its entirety by reference) stiffness in the horizontal direction is required and this can be provided by using an over- or under-sized elastic means so that the compensating force is larger or lower in magnitude than the horizontal force generated by gravity.

In one embodiment the supporting element comprises a middle section; at least two base frame connecting members pivotally attached at one end to said middle section and at the other end to said base frame; and at least two balance mass connecting members pivotally attached at one end to said middle section and at the other end to said balance mass. This embodiment has the advantage that when the balance mass is supported on such a supporting element, during movement of the balance mass in the horizontal direction, the tilt or vertical movement of the balance mass relative to the base frame is minimized.

According to a further aspect of the invention there is provided a device manufacturing method comprising the steps of:
- providing a substrate that is at least partially covered by a layer of radiation-sensitive material on a substrate table positioned on a base frame;
- providing a projection beam of radiation using a radiation system; using patterning means to endow the projection beam with a pattern in its cross-section;
- projecting the patterned beam of radiation onto a target portion of the layer of radiation-sensitive material,
- moving said substrate table relative to said base frame by generating a reaction force between said substrate table and a balance mass supported on said base frame, characterized by supporting said balance mass using at least one flexible supporting element mechanically attached to said balance mass and to said base frame.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam'' are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 depicts the principle of operation of a balance mass according to the invention;
Figure 3 depicts the principle of operation of a balance mass support according to a first embodiment of the present invention;
Figure 4 depicts a supporting element and elastic means of the first embodiment of the present invention;
Figure 5 depicts a combined supporting element and elastic means of the first embodiment of the present invention;
Figure 6 depicts the principle of operation of a second embodiment of the present invention;
Figure 7 depicts the principle of operation of a third embodiment of the present invention;
Figure 8 depicts an elastic hinge of the third embodiment of the present invention;
Figure 9 depicts an alternative design of elastic hinge of the third embodiment of the present invention;
Figure 10 a and b depicts the principle of operation in two dimensions of a fourth embodiment of the present invention;
Figure 11 depicts in detail a bottom half of a practical three dimensional embodiment of the fourth embodiment of the present invention;
Figure 12 depicts in detail a complete practical three dimensional embodiment of the fourth embodiment of the present invention;
Figure 13 depicts the principle of operation of a fifth embodiment of the present invention,
Figure 14 depicts a practical three dimensional embodiment of the sixth embodiment of the present invention;
Figure 15 depicts the principle of operation of the sixth embodiment of the present invention; and
Figure 16 illustrates the principle of operation of a seventh embodiment of the present invention.

In the Figures, corresponding reference symbols indicate corresponding parts.

### Embodiment 1

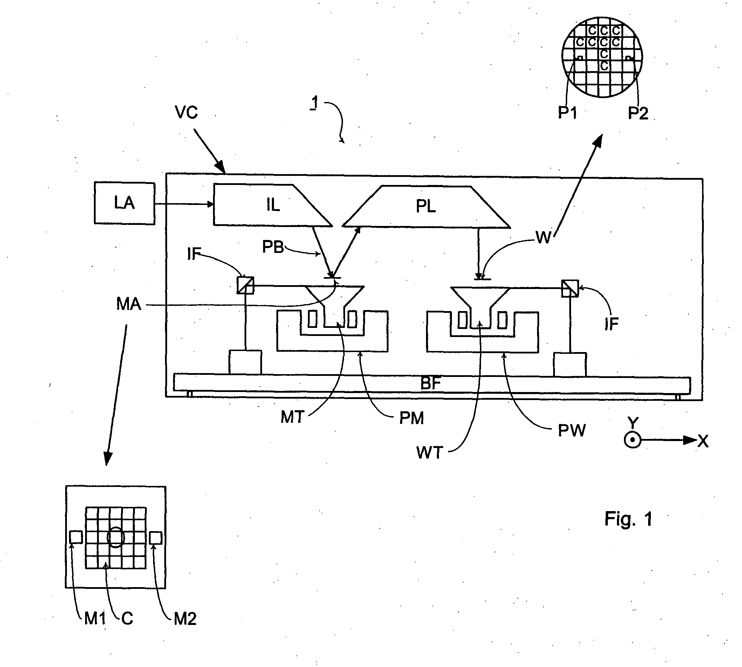

Figure 1 schematically depicts a lithographic projection apparatus according to a particular embodiment of the invention. The apparatus comprises:
· a radiation system Ex, IL, for supplying a projection beam PB of radiation (e.g. EUV radiation), which in this particular case also comprises a radiation source LA;
· a first object table (mask table) MT provided with a mask holder for holding a mask MA (e.g. a reticle), and connected to first positioning means for accurately positioning the mask with respect to item PL;
· a second object table (substrate table) WT provided with a substrate holder for holding a substrate W (e.g. a resist-coated silicon wafer), and connected to second positioning means for accurately positioning the substrate with respect to item PL;
· a projection system ("lens") PL (e.g. mirror group) for imaging an irradiated portion of the mask MA onto a target portion C (e.g. comprising one or more dies) of the substrate W.
As here depicted, the apparatus is of a transmissive type (e.g. has a transmissive mask). However, in general, it may also be of a reflective type, for example (e.g. with a reflective mask). Alternatively, the apparatus may employ another kind of patterning means, such as a programmable mirror array of a type as referred to above.

The source LA (e.g. a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, e.g. so as to position different target portions C in the path of the beam PB. Similarly, the first positioning means can be used to accurately position the mask MA with respect to the path of the beam PB, e.g. after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

As can be seen from Figure 1 a typical EUV apparatus comprises a base plate BP on which the various components of the lithographic projection apparatus are supported.

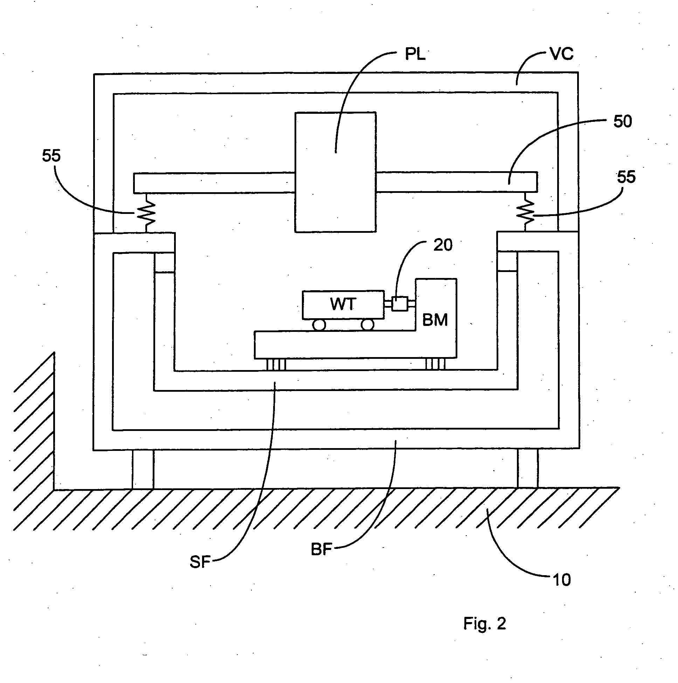

Figure 2 shows that the base plate BP is comprised of a base frame BF which is stiffly connected to the ground 10. Some of the components of the EUV apparatus, such as a substrate table vacuum chamber VC are connected in a stiff manner to the base frame BF. The projection system PL is isolated from vibrations of the base frame BF by being mounted on a metrology frame 50 which is compliantly connected to the base frame BF with springs 55 of an active vibration isolation system (AVIS).

Any disturbance forces on the base frame BF will be partially transmitted to the metrology frame 50 via the mechanical springs 55 of the active vibration isolation system (AVIS). The resulting metrology frame 50 motion will disturb sensors of the wafer stage WT and the position sensors of any optical element in the projection system PL. This will result in large positioning errors and thus in overlay and CD errors.

In order to minimize the disturbance forces on the base frame BF the substrate table WT is positioned on a substrate table support frame SF (which is stiffly connected to the base frame BF) in accordance with Newton's law of conservation of momentum. This is done by providing a positioning actuator 20 between the substrate table WT and a balance mass BM. Both the substrate table WT and the balance mass BM are mounted such that translation or movement in the horizontal plane parallel to the surface of the substrate table support frame SF is substantially free.

On actuation of the positioning actuator 20 to generate a reaction force, the substrate table WT and balance mass BM, translate in opposite directions by different amounts dependent upon the mass ratio balance mass to the substrate table. In this way, the substrate table WT may be positioned relative to the projection system PL using calculations based on Newton's law.

A fly wheel may be arranged on the balance mass which is rotatable in a plane perpendicular to the plane of translational movement of the balance mass. In this way, if the substrate table WT is to be rotated a reaction force may be applied to the balance mass BM by changing the plane of rotation of the fly wheel.

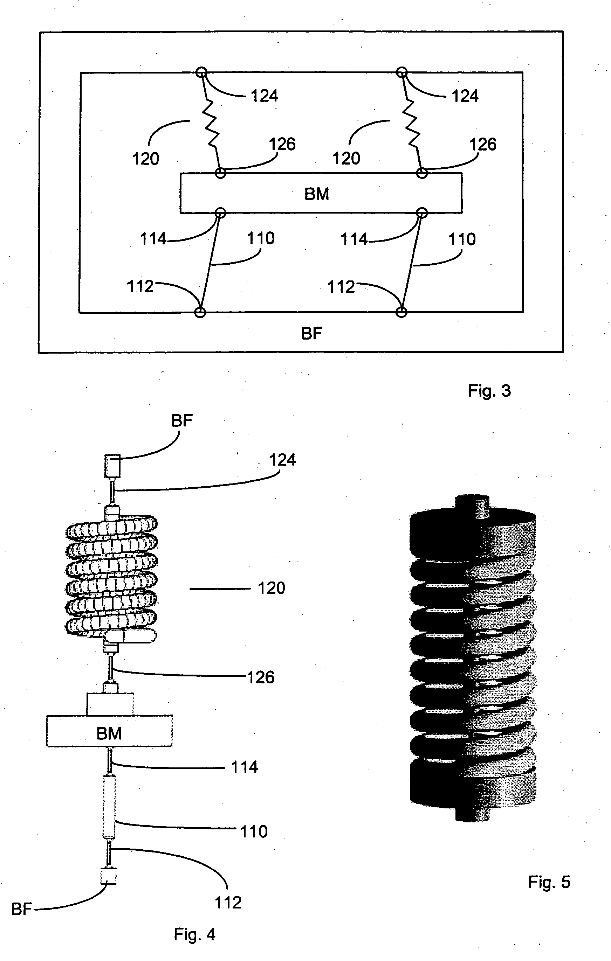

Figure 3 illustrates schematically how the balance mass BM is mounted to the base frame BF in the first embodiment of the present invention.

The balance mass is supported on the base frame by at least one supporting element 110, that is, the supporting element takes the weight of the balance mass BM and transfers it directly to the base frame. In the illustrated embodiment there are two such supporting elements though in practice it is likely that more than two would be required. Preferably there are at least three supporting elements 110 all below, in use, the balance mass. The supporting elements 110 are stiff and preferably pre-tensioned to keep them straight. The supporting elements 110 are pivotally attached to the base frame BF and the balance mass BM at each end by hinges 112, 114. Preferably the hinges 112, 114 are elastic hinges that are formed of elastic material extending between the ends of the stiff bar and the balance mass and base frame respectively so that on deflection of the hinge from the dead ahead position a small force is generated towards the dead ahead position. This is illustrated in Figure 4. Alternatively, in the first embodiment, the hinges 112, 114 may have zero stiffness (i.e. be non-elastic) and be formed from ball bearings for example.

When the balance mass is positioned such that the hinges 112, 114 of each of the supporting elements align vertically there will be no horizontal components of the force generated by gravity on the balance mass BM. However, when the balance mass is positioned such that the hinges 112, 114 of the support elements 110 are not vertically aligned, a horizontal force will be generated by the action of gravity on the balance mass BM. This is termed negative stiffness.

This negative stiffness can be compensated for by applying a compensating force to the balance mass BM using an elastic means. In the first embodiment the elasticity of the hinges 112, 114 is not large enough and so at least one spring 120 is connected between the base frame BF and balance mass BM. By sizing the elastic means i.e. the hinges 112, 114 and the spring 120 correctly, the horizontal force due to the action of gravity on the balance mass BM can be precisely compensated for by the force generated by parasitic horizontal stiffness of the elastic means. The spring 120 is pivoted at either end 124, 126 to the base frame and balance mass with hinges respectively. As illustrated in Figure 4 the hinges may be of the elastic type as used in conjunction with the supporting element 110.

In this way it is possible to provide a support means for the balance mass with a long stroke and low horizontal stiffness (i.e. low horizontal eigen frequency) and high vertical stiffness.

As will be appreciated, the parasitic horizontal stiffness can also be provided for by horizontal springs connected between the balance mass BM and base frame BF.

Figure 5 shows an alternative embodiment in which the elastic means 120 is provided in conjunction with the supporting element 110. This alternative variation has the advantage of being more compact than having separate supporting elements and elastic means. The spring 120, which is about 300 mm long, is pretensioned and connected between the balance mass BM and base frame BF. With this set up, there is no need to have elastic components positioned above the balance mass BM as is illustrated in Figure 3. The spring 120 could be made of any strong and elastic material. Presently preferred materials are spring steel and titanium.

The embodiment can also work the other way up to what is illustrated in Figure 3 i.e. with springs 120 underneath the balance mass BM and being in compression. In that case the supporting elements 110 may be flexible ties such as cables.

### Embodiment 2

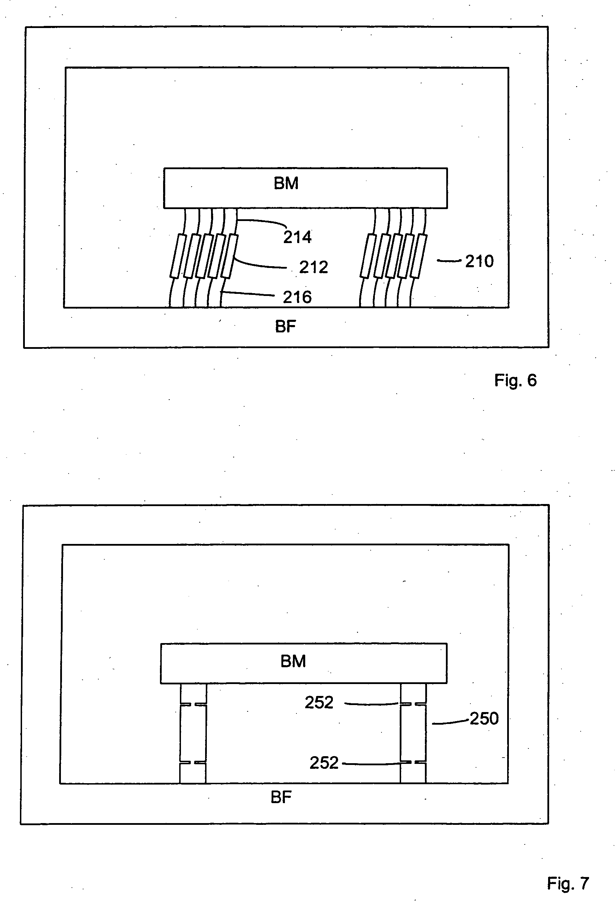

The second embodiment of the invention will now be described with reference to Figures 6 to 9. The second embodiment of the present invention is the same as that of the first embodiment save as described below.

In Figure 6 the balance mass BM is supported on the base frame BF by a plurality of supporting elements 210 which are comprised of elastic rods placed underneath the balance mass BM and mechanically attached to the balance mass BM and the base frame BF. The cross-section of the rod perpendicular to the longitudinal direction is preferably square because the stress at maximum deflection is lowest for such a thin cross section. However, circular or other cross-sections are also possible.

As is illustrated in Figure 6 the rods are designed to pivot above and below a central portion 212 which may or may not be more stiff than the rest of the rod. The same principle as in the first embodiment is applied namely that the horizontal force used on the balance mass due to gravity is compensated for by the elastic means, namely the supporting elements 210 themselves. The amount of force due to gravity is a function of the difference in the lengths between the balance mass center of gravity and the pivot points. The larger the distance, the smaller the stiffness and thus the swing or pendulum eigen frequency.

The theory behind this concept is to use this negative "swing" stiffness to compensate for the (undesired) positive horizontal stiffness of the flexible supporting elements 210. The balance mass BM is free to move in the horizontal direction, with zero parasitic stiffness if the negative swing stiffness exactly compensates the horizontal parasitic stiffness of the flexible mounts. This is achieved by ensuring that the supporting element 210 has pivot points 214, 216 below the center of gravity of the balance mass BM on either side of the central portion 212 of the supporting element 210.

The negative stiffness i.e. the horizontal force due to gravity on the balance mass BM can be easily calculated using basic principles as can the stiffness of the supporting elements 210. It is then a matter of designing the relevant dimensions and stiffnesses such that those two forces are equal. If the balance mass BM weighs about 2000 kg, it has been found that two sets of rods with 25 rods in each set and with a diameter of 3.7 mm and a length of 300 mm between pivot points (and an overall length of 350 mm) works well. In this case, a maximum vertical displacement, which is undesirable, of only 240 µm is present at a maximum horizontal displacement of 12 x 10⁻³m for a tolerable mechanical stiffness of 6 to 10 N/mm in the horizontal direction and 7 x 10⁷ N/m in the vertical direction.

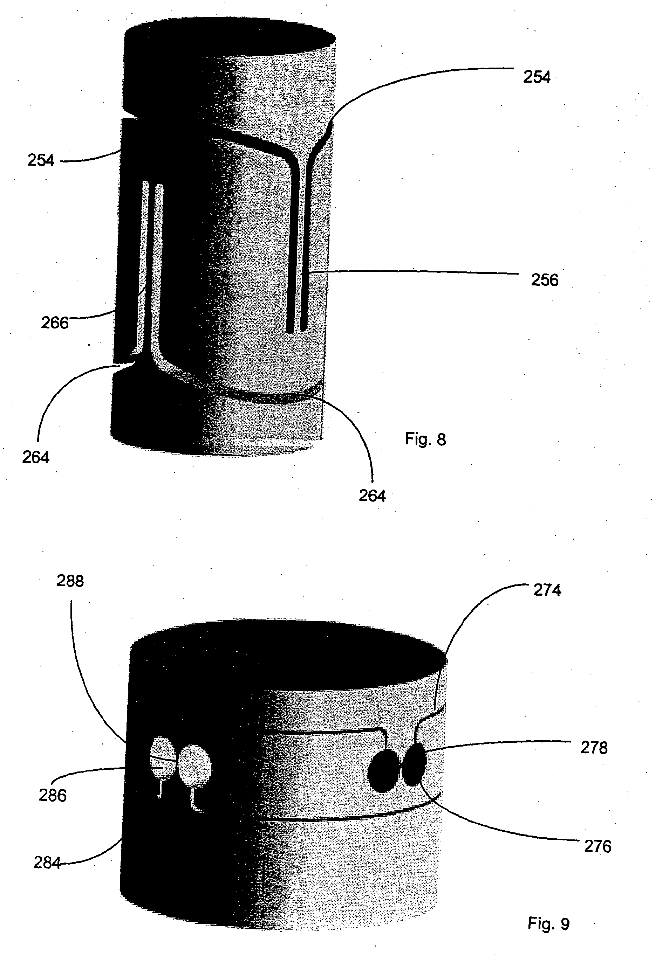

Figure 7 illustrates an alternative arrangement to the arrangement shown in Figure 6. In this arrangement the supporting elements are cardanic beams 250 which are stiff except for two pivot points 252 formed by hinges one positioned closer to the balance mass and one closer to the base frame. The two hinges 252 are elastic in nature such that they provide the force which compensates for the force on the balance mass due to gravity. Figures 8 and 9 illustrate two embodiments of hinge 252 in which it can be seen that they are preferably manufactured of solid material which should be strong and elastic. Example materials are spring steel and titanium.

In each of the hinges illustrated the material is machined away from the solid rod such that only small slices of material are left which can be deformed by typical forces involved in the present invention.

In the hinge illustrated in Figure 8 first cuts 254 are made in the solid rod to leave only a slice 256 of material in the longitudinal direction of the rod supporting the load. Second cuts 264 leave only a second slice 266. The two slices 256, 266 in the longitudinal direction are positioned orthogonally such that cardanic movement in two dimensions of the hinge is possible by compliant binding of the slices 256, 266.

In the embodiment illustrated in Figure 9 cuts 274, 284 in combination with two sets of two holes 276, 286 drilled through the rod at orthogonal angles each perpendicular to the longitudinal direction of the rod leave two slices 276, 286 of material supporting the load. Thus movement in two dimensions of the top part of the rod relative to the bottom part is possible.

For the cardanic system of Figure 7, calculations have shown that three cardanic beams with a length of 500 mm between pivot points and a total length of 583 mm with a square cross section of 100 mm by 100 mm gives satisfactory results for a maximum horizontal displacement of 12 x 10⁻³m. In this case the maximum vertical displacement is only 144 µm.

### Embodiment 3

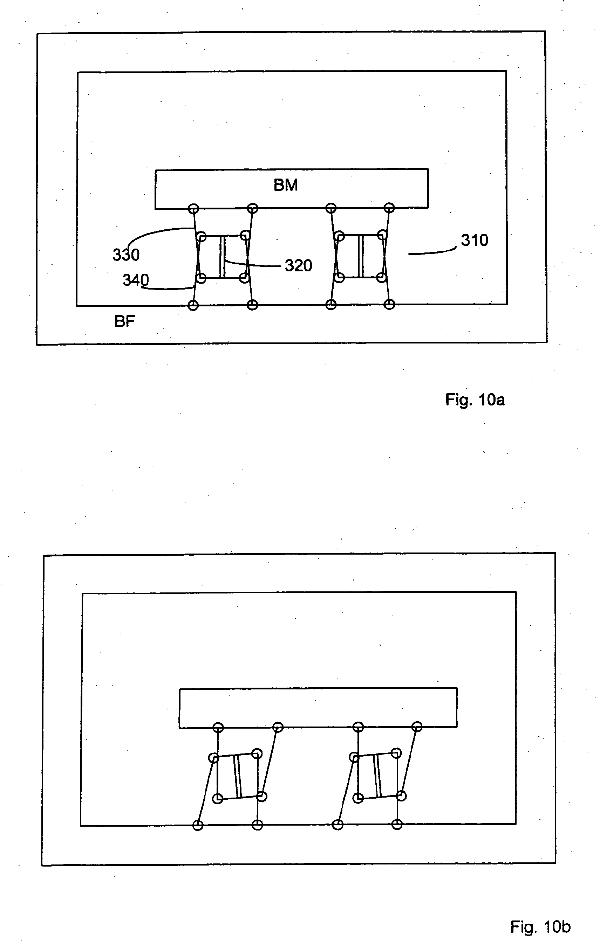

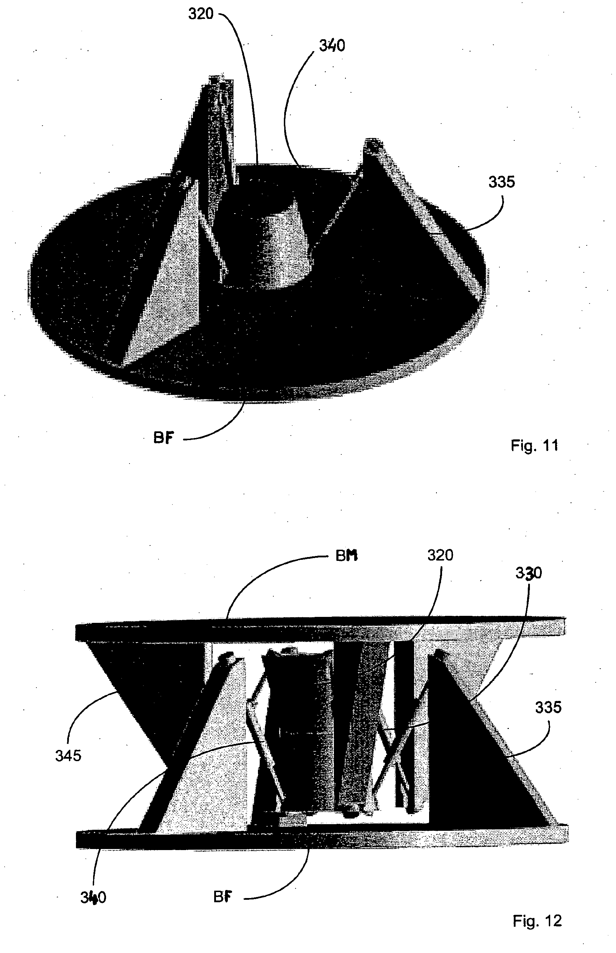

The third embodiment will be described with reference to a two dimensional system i.e. one which allows movement with one degree of freedom in Figures 10 and a three dimensional system i.e. one which allows movement with two degrees of freedom in Figure 11. The third embodiment is the same as the first embodiment save as described below.

As can be seen from Figure 10 the balance mass in the third embodiment is supported by supporting elements 310. In the illustrated embodiment the supporting elements 310 are shown as being positioned underneath the balance mass BM. However, in practice the supporting elements 310 may be positioned either above or below the balance mass BM. Preferably there are at least three supporting elements 310.

In contrast to the first and second embodiments, in the third embodiment the vertical height of the balance mass BM relative to the base frame BF does not change significantly on horizontal movement of the balance mass. This is affected by use of the supporting element 310. Figures 10a and 10b shows how this is possible in two dimensions and Figures 11 and 12 show how the system can be adapted to three dimensions.

Referring to Figures 10a and b, each supporting element 310 is comprised of a middle section 320 which provides for indirect connection between the balance mass BM and the base frame BF (about 150 mm apart). Balance mass connecting members 330 are pivotally connected to the balance mass and pivotally connected to the middle section 320. Similarly, base frame connecting members 340 are pivotally connected between the base frame BF and the middle section 320. The pivotal connections are provided by hinges.

The middle section 320 has, in the illustrated embodiment, an I shape. However, any shape may be used so long as the balance mass connecting members 330 may be connected in a single plane to the middle section 320 and the base frame connecting members may also be connected in a single plane separate from the plane in which the balance mass connecting members are connected to the middle section 320. Preferably the lengths of all of the base frame connecting members 340 are the same and the lengths of all of the balance mass connecting members 330 are the same. In this way it is possible for the balance mass BM to be moved in the horizontal direction relative to the base frame BF without the balance mass BM being vertically displaced. As can be seen from Figure 10b this occurs by rotation of the middle section 320 and by changing of the angle of the base frame and balance mass connecting members to the balance mass, base frame and middle section. Thus all of the components of the supporting elements 310 are stiff (except the hinges). The pivot points, i.e. the hinges, between the connecting members 330, 340, the balance mass BM, the base frame BF and the middle section 320 are free running so that the balance mass BM may be moved in the horizontal direction with a stroke of up to 30 mm with little horizontal stiffness but high vertical stiffness.

In Figures 11 and 12 another embodiment is illustrated which uses the same two dimensional principles as illustrated in Figures 10a and 10b in three dimensions. In this embodiment the bottom half (Figure 11) comprises base frame connecting members 340 connected to a middle section 320. This is achieved by providing supports 335 which extend from the plane of the base frame BF towards the balance mass BM and to which the base frame connecting members 340 are connected. The supports 335 ensure that the connecting members 340 are loaded with tension only. Therefore, no buckling effects are to be expected. For the bottom half illustrated in Figure 11, the connecting members 340 may be flexible ties such as cables. A similar arrangement with balance mass supports 345 is used for the upper half illustrated in Figure 12. The pivotal attachments between the base frame connecting members 340 and the base frame supports 335 are closer to the balance mass than the pivotal connection between the balance mass connecting members 330 and the balance mass supports 345. Thus the construction for the three dimensional embodiment is reversed from that of the two dimensional embodiment but the principle of operation is the same. Rotation of the balance mass BM is also provided for because the middle section 320 is in an upper and a lower part which parts are rotatable relative to each other around an axis perpendicular to the planes of the balance mass BM and base frame BF.

If the middle section 320 does not have upper and lower parts which are rotatable relative to one another, rotation of the balance mass BM relative to the base frame BF will result in a small vertical translation.

In both the two and three dimensional embodiments, the balance mass and base frame supporting elements pass through some common planes which are parallel to the balance mass BM and the base frame BF planes.

### Embodiment 5

The fifth embodiment will be described with reference to a two dimensional system i.e. one which allows movement with one degree of freedom, but can also be applied as a three dimensional system allowing for three degrees of freedom (x, y, Rz). The fifth embodiment is the same as the first embodiment except as described below.

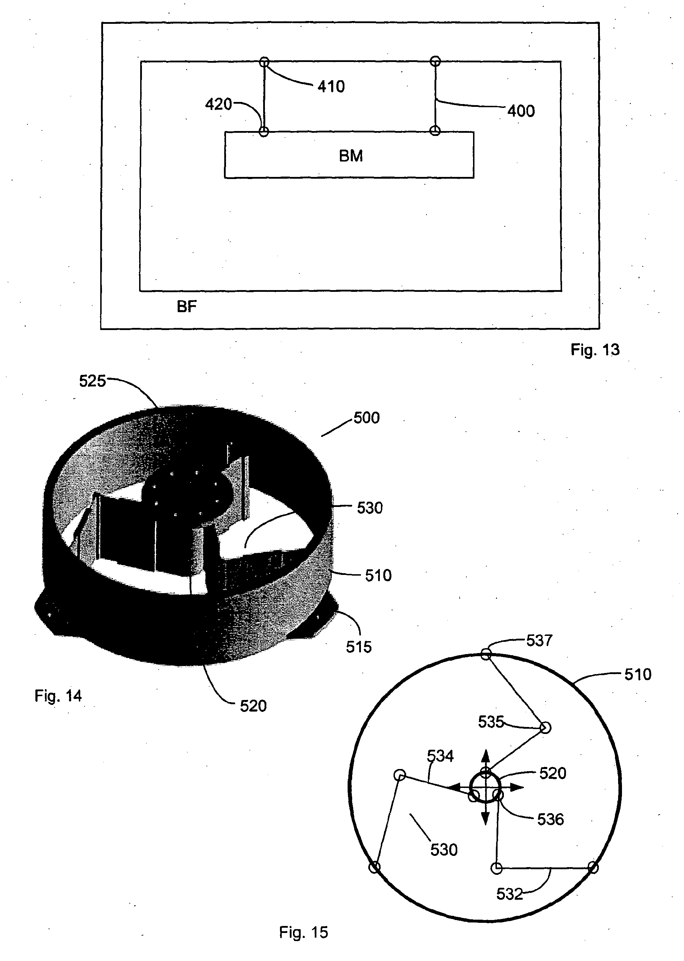

As is illustrated in Figure 13, the balance mass BM is supported on the base frame BF by supporting elements 400 which are ties i.e. they are in tension. The supporting elements 400 have two pivot points 410, 420 and the supporting element 400 can bend at those pivot points at least. As illustrated, the pivot points 410, 420 are hinges at the position at which the supporting element 400 is attached to the base frame BF and balance mass BM. However, this is not necessarily the case, especially in the instance where the supporting element 400 is comprised of a flexible element such as a cable. In this case, hinges do not need to be provided and the two pivot points are formed naturally by the tie as the balance mass moves from side to side.

As the balance mass moves to one or the other side from its equilibrium position, it will experience a centering force on it due to gravity. This centering force is, in some circumstances, desirable because it means that the balance mass will not drift away from its central position.

### Embodiment 6

The sixth embodiment will be described with reference to Figures 14 and 15. The sixth embodiment is the same as the first embodiment except as described below.

In the sixth embodiment the balance mass BM is supported by at least one balance mass supporting member 500. Preferably there are at least three balance mass supporting members 500 supporting the balance mass BM on the base frame BF. The balance mass supporting member 500 is comprised of an outer structure 510, in the illustrated embodiment, in the form of a ring. The outer structure 510 is attached to the base frame BF through attachment points 515.

The balance mass BM is attached to a central structure 520 of the balance mass supporting member 500 which is positioned within the outer structure 510. In the illustrated embodiment the central structure 520 has a top plate 525 which is attached to the balance mass BM. The top plate 525 is flexible for rotations so as to allow the balance mass BM to move relative to the central structure 520. Alternatively the top plate 525 can be replaced with a ball and socket arrangement which allows the balance mass BM to rotate relative to the central structure 520 thereby making rotations around the Rz axis (the optical axis) possible.

As is most clearly seen in Figure 15, the central structure 520 is attached to the outer structure 510 by supporting elements 530. Preferably there are at least three supporting elements 530 which are strong enough to support the weight of the balance mass BM. The supporting elements 530 are hinged at the positions at which they are attached to the outer structure 510 and the central structure 520 (positions 536, 537) and also close to the center of the supporting element at position 535. These pivot points 535, 536, 537 allow relative rotation of the parts they connect around an axis which is substantially orthogonal to the plane in which the balance mass moves. Elements 532 and 534 which are positioned between the pivot points are engineered so that they do not bend under the loads experienced. For this reason they are flat with their main plane being orthogonal to the plane in which the balance mass BM moves.

Preferably the supporting elements 530 are comprised of two leaf springs which are attached together with an elastic hinge 535. Thus when the central structure 520 moves relative to the outer structure 510, the supporting elements 530 bend at pivot points 535, 536, 537 and the force exerted by the elastic hinges provides a small centralizing force on the central structure 520. This can be advantageous in that drift of a balance mass BM away from a central equilibrium position can be reduced. Of course the pivot points 535, 536 and 537 may be near frictionless hinges.

One way to manufacture the supporting elements 530 of the sixth embodiments is by machining the whole of the balance mass supporting member 500 from one piece of material. The supporting elements 530 can be made of a single piece of material in which the pivot portions 535, 536, 537 are manufactured to be thinner than the non-bending portions 532, 534. This is what is illustrated in Figure 14.

If the balance mass supporting member 500 is of the order of 300 mm in diameter, this allows the central portion 520 to have a range of motion of about 10 mm from its central position. This is enough for the balance mass BM to perform its proper function. Alternatively, the balance mass may also be supported by at least three supporting members 530 connected between the base frame and the balance mass.

### Embodiment 7

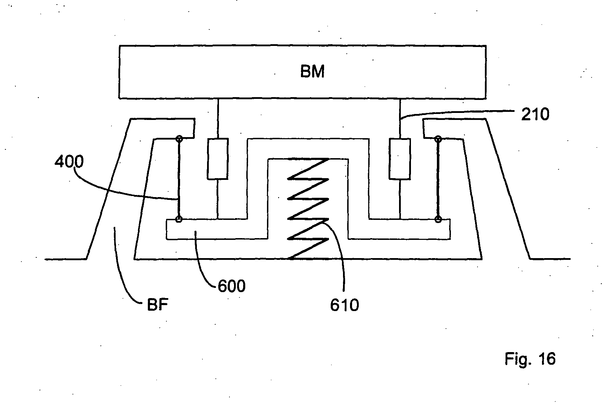

The seventh embodiment will be described with reference to a two dimensional system i.e. one which allows movement with one degree of freedom, with reference to Figure 16. The seventh embodiment is the same as the first embodiment save as described below.

The seventh embodiment is a hybrid embodiment in which the balance mass BM is supported by supporting elements 210, described in relation to Figure 6 above, on an intermediate frame 600. The intermediate frame 600 is attached to the base frame BF with supporting elements 400 as previously described with reference to Figure 13. Optionally this intermediate frame 600 is also partially supported by a compression spring 610 connected between the intermediate frame 600 and the base frame BF.

The seventh embodiment illustrates that features of all of the embodiments described above may be used in combination with each other thereby to provide a support for the balance mass which is suitable for a vacuum environment.

Whilst specific embodiments of the invention have been described above, it will be appreciated that the invention may be practiced otherwise than as described. The description is not intended to limit the invention.

## Claims

1. A lithographic projection apparatus comprising:
- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate;
- a base frame; and
- a balance mass supported on said base frame and moveable relative to said base frame,
**characterized in that** said balance mass is supported by at least one flexible supporting element mechanically attached to said balance mass and to said base frame and having at least two pivot points.

2. A lithographic projection apparatus according to claim 1, wherein on displacement of said balance mass from an equilibrium position in which said pivot points align vertically, a horizontal force in the direction of movement of the balance mass is generated by the action of gravity on said balance mass.

3. A lithographic projection apparatus according to claim 2, further comprising elastic means to provide a compensating force on said balance mass opposite in direction to said horizontal force generated by gravity.

4. A lithographic projection apparatus according to claim 3, wherein said pivot points are hinges.

5. A lithographic projection apparatus according to claim 3 or 4, wherein said elastic means comprise springs attached between said balance mass and said base frame.

6. A lithographic projection apparatus according to any one of claims 3 to 5, wherein said hinges are spring hinges and said hinges form at least part of said elastic means.

7. A lithographic projection apparatus according to claim 3, wherein each supporting element is an elastic rod member providing said elastic means and said elastic member is constructed such that said at least two pivot points are situated at different distances from said balance mass.

8. A lithographic projection apparatus according to claim 7, wherein a longitudinal central portion of said elastic rod member is less elastic than the remainder of said elastic member.

9. A lithographic projection apparatus according to claim 1, wherein said supporting element comprises a middle section; at least two base frame connecting members pivotally attached at one end to said middle section and at the other end to said base frame; and at least two balance mass connecting members pivotally attached at one end to said middle section and at the other end to said balance mass.

10. A lithographic projection apparatus according to claim 9, wherein said base frame connecting members are connected in one plane to said middle section and said balance mass connecting members are connected in another separate plane to said middle section.

11. A lithographic projection apparatus according to any one of the preceding claims, wherein at least one of said at least one flexible supporting element is in tension and is comprised of a cable.

12. A lithographic projection apparatus according to claim 1, wherein said pivot points of said at least one flexible supporting member have pivot axes which are substantially perpendicular to the plane in which said balance mass moves.

13. A device manufacturing method comprising the steps of:
- providing a substrate that is at least partially covered by a layer of radiation-sensitive material on a substrate table positioned on a base frame;
- providing a projection beam of radiation using a radiation system;
- using patterning means to endow the projection beam with a pattern in its cross-section;
- projecting the patterned beam of radiation onto a target portion of the layer of radiation-sensitive material,
- moving said substrate table relative to said base frame by generating a reaction force between said substrate table and a balance mass supported on said base frame,
**characterised by** supporting said balance mass using at least one supporting element having at least two pivot points and being mechanically attached to said balance mass and to said base frame.
